# EUROPEAN PATENT APPLICATION

(11) **EP 4 682 941 A1**
(43) Date of publication of application: **21.01.2026**
(21) Application number: 25761358.8
(22) Date of filing: 20.02.2025
(51) Int. Cl.: H01L 21/3065

(54) **ETCHING GAS**

(30) Priority: 26.02.2024 JP 2024026453
(71) Applicant: DAIKIN INDUSTRIES, LTD., Osaka-Shi, Osaka 530-0001 (JP)
(72) Inventor: TAKAKURA, Yohei, Osaka-Shi, Osaka 530-0001 (JP); NAKAMURA, Hiroki, Osaka-Shi, Osaka 530-0001 (JP); HAYASHI, Hisataka, Osaka-Shi, Osaka 530-0001 (JP); NOJIRI, Yasuhiro, Osaka-Shi, Osaka 530-0001 (JP); SHIMOSUKI, Takumi, Osaka-Shi, Osaka 530-0001 (JP); YAMAMOTO, Suzuka, Osaka-Shi, Osaka 530-0001 (JP)
(74) Representative: Hoffmann Eitle
(86) International application number: PCT/JP2025/005789
(87) International publication number: WO 2025/182748

(57) **Abstract**

An object of the present disclosure is to newly provide an etching gas. Etching gas.

## Description

### Technical Field

The present disclosure relates to etching gases.

### Background Art

PTL 1 discloses etching gases CF₃COCF₃ (hexafluoroacetone) and C₃F₆O (hexafluoropropene oxide), and an etching method in which these etching gases and argon gas are introduced into a processing chamber at a flow rate ratio of 1:10 to 30, and an oxide silicon-based material layer on a substrate to be processed is etched in a plasma atmosphere in the processing chamber.

### Citation List

### Patent Literature

PTL 1: JPH09-129612A

### Summary of Invention

### Technical Problem

An object of the present disclosure is to newly provide an etching gas containing 1,2-difluoroethylene (CHF=CHF).

### Solution to Problem

The present disclosure includes the following subject matter.

Item 1. An etching gas comprising 1,2-difluoroethylene (CHF=CHF) .

Item 2. A method for etching a substrate for producing a semiconductor using the etching gas of Item 1.

Item 3. A semiconductor production apparatus comprising a gas ejection port for the etching gas of Item 1.

Item 4. A method for producing a semiconductor, comprising etching a substrate for producing a semiconductor using the etching gas of Item 1.

Item 5. Use of the etching gas of Item 1 in the production of a semiconductor, wherein etching is performed on a substrate for producing a semiconductor.

### Advantageous Effects of Invention

The present disclosure newly provides an etching gas containing 1,2-difluoroethylene (CHF=CHF).

### Description of Embodiments

In the present specification, the term "comprising" includes the concepts of comprising, consisting essentially of, and consisting of. In the present specification, a numerical range indicated as "A to B" means A or more and B or less. In the present specification, units such as parts and % represent parts by mass, parts by weight, mass%, or weight% (wt%).

### 1. Etching Gas

In traditional semiconductor production, the microfabrication process poses a high environmental impact, using gases with high global warming potential (GWP), such as c-C₄F₈ (GWP: 10,300), CF₄ (GWP: 7,390), SF₆ (GWP: 24,300), CHF₃ (GWP: 14,800), and CH₂F₂ (GWP: 675).

The present disclosure encompasses an etching gas containing 1,2-difluoroethylene (CHF=CHF) used for etching a substrate for producing a semiconductor during semiconductor production.

### 1,2-Difluoroethylene

The etching gas of the present disclosure can perform etching in an excellent manner on a substrate for producing semiconductors due to the use of 1,2-difluoroethylene (CHF=CHF), which is a low-GWP gas.

In the etching gas of the present disclosure, from the viewpoint of etching rate (ER), the 1,2-difluoroethylene for use is preferably at least one selected from the group consisting of trans-1,2-difluoroethylene (HFO-1132(E)) and cis-1,2-difluoroethylene (HFO-1132(Z)), and more preferably trans-1,2-difluoroethylene (HFO-1132(E), GWP: 0.0036).

The etching gas of the present disclosure for use may be a single type of 1,2-difluoroethylene or a combination (blend) of two or more types.

### Other Etching Gases

The etching gas of the present disclosure may contain other etching gases, including hydrofluorocarbon compounds (HFCs), such as CH₂F₂, CHF₃, C₂H₂F₂ (1,1-difluoroethylene), C₂H₄F₂, and C₃H₂F₄; perfluorocarbon compounds (PFCs), such as CF₄, C₂F₆, C₃F₈, C₄F₈, C₃F₆, C₄F₆, and C₅F₈; iodides, such as CF₃I, C₂F₅I, and C₃F₇I; and SF₆.

The etching gas of the present disclosure may contain other etching gases singly or in a combination (blend) of two or more types.

### Inert Gas

The etching gas of the present disclosure may contain an inert gas as needed from the viewpoint of etching rate (ER). The inert gas may be one or more types such as noble gases and nitrogen. Noble gases include helium, neon, argon, xenon, and krypton, with argon being preferably used. These inert gases may be used singly or in a combination (blend) of two or more types.

### Etching Gas

The etching gas of the present disclosure has a high etching rate (ER) for substrates for producing semiconductors.

The etching gas of the present disclosure is a low-GWP gas that enables environmentally low-impact and sustainable microfabrication technology for substrates for producing semiconductors.

### 2. Method for Performing Etching

The present disclosure encompasses a method for etching using the etching gas containing 1,2-difluoroethylene (CHF=CHF) of the present disclosure as a gas supplied to generate plasma for a substrate for producing semiconductors.

### 3. Semiconductor Production Apparatus

The present disclosure encompasses a semiconductor production apparatus comprising a gas ejection port for the etching gas containing 1,2-difluoroethylene (CHF=CHF) of the present disclosure.

### 4. Method of Producing Semiconductor

The present disclosure encompasses a method for producing a semiconductor, comprising etching a substrate for producing a semiconductor by using the etching gas containing 1,2-difluoroethylene (CHF=CHF) of the present disclosure.

### 5. Use for Semiconductor Production

The present disclosure encompasses use of the etching gas containing 1,2-difluoroethylene (CHF=CHF) of the present disclosure in the production of a semiconductor, wherein etching is performed on a substrate for producing a semiconductor.

The etching gas of the present disclosure has a favorable etching rate (ER) for substrates such as Si used in the production of semiconductors, leading to improved productivity of substrates for producing semiconductors.

The above describes an embodiment of the present disclosure. Various modifications in form and details can be made without departing from the spirit and scope of the claims.

### Examples

The following explains the present disclosure in detail with reference to Examples and Comparative Examples. The present disclosure is not limited to only these Examples.

### Plasma Treatment Method in Examples and Comparative Examples

### (1) Etching

Etching performance was evaluated using a gas containing 1,2-difluoroethylene (CHF=CHF). Etching was performed on deposition films (P-TEOS film, P-SiN film, PolySi film, and ACL film) using a capacitively coupled plasma (CCP) apparatus and a gas containing CHF=CHF.

### Etching Conditions

HF (High Frequency): 1,000 W (40 MHz)
LF (Low Frequency): 2,000 W (13.56 MHz)
Pressure: 20 mTorr
Top temp: 80°C
Wall temp: 80°C
ESC: 40°C
Etching time: 30 s
Gas containing CHF=CHF: 10 sccm
Ar: 100 sccm

**Table 1**

| Table 1: Etching Performance | | | |
|---|---|---|---|
| Etching Rate (ER) (nm/min) | | | |
| P-TEOS Film | P-SiN Film | PolySi Film | ACL Film |
| 145.4 | 81.7 | 64.6 | 30.4 |

In the Examples (etching using CHF=CHF), etching could be performed on deposition films such as a P-TEOS film, a P-SiN film, a PolySi film, and an ACL film in the plasma treatment method. The etching gas containing 1,2-difluoroethylene (CFH=CFH) of the present disclosure has a favorable etching rate (ER) and is useful as an etching gas.

## Claims

1. An etching gas comprising 1,2-difluoroethylene (CHF=CHF) .

2. A method for etching a substrate for producing a semiconductor using the etching gas of claim 1.

3. A semiconductor production apparatus comprising a gas ejection port for the etching gas of claim 1.

4. A method for producing a semiconductor, comprising etching a substrate for producing a semiconductor using the etching gas of claim 1.

5. Use of the etching gas of claim 1 in the production of a semiconductor, wherein etching is performed on a substrate for producing a semiconductor.
